# EUROPÄISCHE PATENTANMELDUNG

(11) **EP 4 015 285 A1**
(43) Veröffentlichungstag der Anmeldung: **22.06.2022**
(21) Anmeldenummer: 21206305.1
(22) Anmeldetag: 03.11.2021
(51) Int. Cl.: B60L 53/10, B60L 53/31, B60L 53/62, B60L 53/67, H05K 1/00

(54) **ANORDNUNG ZUR INTEGRATION IN EINE LADEVORRICHTUNG FÜR WENIGSTENS EIN ELEKTROFAHRZEUG**

(30) Priorität: 21.12.2020 DE 102020134453
(71) Anmelder: Innogy eMobility Solutions GmbH, 44139 Dortmund (DE)
(72) Erfinder: Matschke, Andre, 48739 Legden (DE); Saleh, Mohamed Fouad Abdou, 58099 Hagen (DE); Müller-Winterberg, Christian, 46282 Dorsten (DE)
(74) Vertreter: Gottschald Patentanwälte Partnerschaft mbB

(57) **Zusammenfassung**

Die Erfindung betrifft eine Anordnung (10) zur Integration in eine Ladevorrichtung (1) für wenigstens ein Elektrofahrzeug, aufweisend:
- wenigstens eine Leistungseinheit (20) für eine Bereitstellung eines elektrischen Ladestroms,
- wenigstens einen Ladepunkt (30),
- wenigstens eine Leiterplatte (40),
- wenigstens eine Schalteinheit (50), welche an der Leiterplatte (40) zum Schalten des bereitgestellten Ladestroms angeordnet ist,
wobei die wenigstens eine Schalteinheit (50) die wenigstens eine Leistungseinheit (20) mit dem wenigstens einen Ladepunkt (30) elektrisch verbindet, um den bereitgestellten Ladestrom an das Elektrofahrzeug zu übertragen.

## Beschreibung

Die vorliegende Erfindung betrifft eine Anordnung zur Integration in eine Ladevorrichtung für wenigstens ein Elektrofahrzeug. Ferner bezieht sich die Erfindung auf eine Ladevorrichtung und ein Verfahren zu diesem Zweck.

Es ist aus dem Stand der Technik bekannt, dass Ladevorrichtungen, wie Gleichstromschnellladestationen (DC-Schnellladestationen), mit einer DCseitigen Nennleistung größer als 50 kW mit zwei oder mehr Ladepunkten ausgestattet werden. Um die Verfügbarkeit der Ladevorrichtung zu erhöhen, wird zudem ein paralleles Laden an den Ladepunkten der Ladevorrichtung ermöglicht. Für die Aufteilung der Leistung werden üblicherweise DC Schütze verwendet, welche den Ladestrom schalten und auf diese Weise eine Verteilung des Ladestroms vornehmen können. Allerdings hat dieser herkömmliche Aufbau erhöhte technische Anforderungen, welche somit mit erhöhtem technischen Aufwand für die Herstellung, Montage und Wartung einhergehen.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Lösung für die Bereitstellung und Übertragung des Ladestroms vorzuschlagen.

Die voranstehende Aufgabe wird gelöst durch eine Anordnung mit den Merkmalen des Anspruchs 1 und durch eine Ladevorrichtung mit den Merkmalen des Anspruchs 11 sowie durch ein Verfahren mit den Merkmalen des Anspruchs 14. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit der erfindungsgemäßen Ladevorrichtung sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Anordnung, insbesondere elektrische Schaltungsanordnung und/oder Baugruppe, zur Integration in eine Ladevorrichtung, insbesondere Ladestation, für wenigstens ein Fahrzeug, bevorzugt Elektrofahrzeug, besonders bevorzugt zum Aufladen des Elektrofahrzeuges, aufweisend:
- wenigstens eine (insbesondere elektrische) Leistungseinheit oder mehrere Leistungseinheiten (jeweils) für eine Bereitstellung eines elektrischen Ladestroms und/oder einer elektrischen Leistung zur Aufladung des Fahrzeuges, wobei vorzugsweise (jeweils) eine elektrische Leistung von mindestens 10 kW oder mindestens 30 kW bereitgestellt wird,
- wenigstens einen Ladepunkt oder mehrere Ladepunkte, vorzugsweise jeweils aufweisend einen oder mehrere elektrische Anschlüsse,
- wenigstens eine Leiterplatte,
- wenigstens eine (insbesondere elektrische) Schalteinheit oder mehrere Schalteinheiten, welche (jeweils) an der Leiterplatte zum Schalten des bereitgestellten Ladestroms angeordnet ist bzw. sind und/oder elektrisch leitend mit der Leiterplatte befestigt sind.

Hierbei ist insbesondere vorgesehen, dass die wenigstens eine Schalteinheit die wenigstens eine Leistungseinheit mit dem wenigstens einen Ladepunkt elektrisch verbindet, um den bereitgestellten Ladestrom an das Fahrzeug bzw. an das Elektrofahrzeug zu übertragen. Die erfindungsgemäße Anordnung kann bspw. als eine integrierte und/oder automatisiert fertigbare Baugruppe ausgebildet sein. Die vorgesehene Ausbildung der Anordnung senkt sowohl die Einzelkomponentenkosten als auch die Prozesskosten und erhöht gleichzeitig die Prozesssicherheit.

Die Verwendung eines solchen Leiterplattendesigns hat insbesondere den Vorteil (bspw. gegenüber einer herkömmlichen Lösung, die als Schalteinheit ein Schütz verwendet), dass die technische Umsetzung einfacher ist, und der Aufwand für die Montage reduziert werden kann. Darüber hinaus besteht weniger Verbindungsaufwand, sodass diese Lösung auch weniger fehleranfällig ist.

Erfindungsgemäß kann es vorgesehen sein, dass die jeweilige Schalteinheit an der Leiterplatte angeordnet und/oder befestigt ist, also leiterplattenbasiert ausgebildet ist. Dies bedeutet insbesondere, dass der Ladestrom über wenigstens eine Leiterbahn der Leiterplatte an die Schalteinheit übertragen wird, und die Schalteinheit elektrisch leitend direkt mit der Leiterbahn verbunden sein kann, z. B. daran verlötet sein kann. Die Verwendung eines Schützes als Schalteinheit kann dagegen nicht leiterplattenbasiert sein, also das Schütz nicht auf einer Leiterplatte angeordnet sein, sodass der technische Aufwand herkömmlicherweise erhöht ist.

Die Schalteinheit ist z. B. eine leiterplattenbasierte Schalteinheit, insbesondere ein Leiterplattenrelais oder ein Leistungshalbleiterschalter oder dergleichen. Als Schalteinheit kann ferner auch ein Hochleistungsrelais verwendet werden. Die wenigstens eine Schalteinheit kann dabei auch mehrere Schalteinheiten aufweisen, die eine leiterplattenbasierte Schaltmatrix ausbilden. Die leiterplattenbasierte Schaltmatrix kann dazu ausgeführt sein, eine hohe Isolationsfestigkeit für die Ladepunkte bereitzustellen.

Die erfindungsgemäße Anordnung kann dadurch zur Integration in die Ladevorrichtung ausgeführt sein, dass die Anordnung wenigstens ein Befestigungsmittel aufweist, um die Anordnung in einem Gehäuse der Ladevorrichtung anzubringen. Alternativ oder zusätzlich kann die erfindungsgemäße Anordnung wenigstens einen elektrischen Anschluss aufweisen, um mit einer Elektrik und/oder Elektronik der Ladevorrichtung elektrisch verbunden zu werden. Bspw. erfolgt eine elektrische Verbindung der wenigstens einen Leistungseinheit mit einer Energieversorgung der Ladevorrichtung, bspw. einer Wechselspannungsquelle.

Die Ladevorrichtung kann für wenigstens ein Elektrofahrzeug (nachfolgend auch kurz als Fahrzeug bezeichnet), also zur Aufladung des Elektrofahrzeuges, geeignet sein. Das Fahrzeug ist bspw. ein Elektrokraftfahrzeug mit einer Batterie zur Energieversorgung des Antriebs und/oder ein Personenkraftfahrzeug und/oder ein Lastkraftfahrzeug. Dabei kann die Ladevorrichtung ggf. auch für mehrere Elektrofahrzeuge gleichzeitig die Aufladung bereitstellen, wenn mehrere Ladepunkte vorgesehen sind. Falls die Aufladung parallel für unterschiedliche Elektrofahrzeuge über unterschiedliche Ladepunkte der Ladevorrichtung erfolgt, muss die verfügbare elektrische Leistung der wenigstens einen Leistungseinheit auf die Ladepunkte aufgeteilt werden. Hierzu kann die wenigstens eine Schalteinheit eine Verteilung der elektrischen Leistung ermöglichen.

Die Bereitstellung des elektrischen Ladestroms durch die wenigstens eine Leistungseinheit kann auch als eine Bereitstellung der elektrischen Leistung verstanden werden, wobei die Gesamtleistung der Leistungseinheit(en) auf die verfügbaren und aktivierten Ladepunkte aufgeteilt wird. Die jeweilige Leistungseinheit weist z. B. eine Leistung von mindestens 10 kW oder 20 kW oder 30 kW auf, welche insbesondere zur Gesamtleistung der Ladevorrichtung addiert werden. Ein Ladepunkt wird bspw. dadurch aktiviert, dass ein Benutzer den Ladepunkt mit dem Batteriesystem des Fahrzeuges elektrisch verbindet (z. B. über einen Ladestecker) und/oder sich an der Ladevorrichtung authentifiziert. Auf diese Weise kann der Ladevorgang gestartet werden. Das Batteriesystem des Fahrzeuges kann einen Akkumulator aufweisen, welcher mit Gleichstrom geladen wird.

Die Ladevorrichtung kann zum Gleichstromladen ausgebildet sein. Dabei wird der bereitgestellte Ladestrom als Gleichstrom über den Ladepunkt direkt in das Fahrzeug eingespeist. Die Leistungseinheit kann die für die Bereitstellung des elektrischen Ladestromes notwendige Energie z. B. aus dem Stromnetz und/oder aus Akkumulatoren der Ladevorrichtung (z. B. bei Solartankstellen) ziehen. Im Fahrzeug kann ein Batteriemanagementsystem vorgesehen sein, welches mit der Ladevorrichtung kommuniziert, um bspw. die Stromstärke des Ladestroms anzupassen und/oder den Ladevorgang (und damit auch den entsprechend dafür genutzten Ladepunkt) zu aktivieren und/oder zu deaktivieren. Der jeweilige Ladepunkt selbst kann hierzu ferner einen zur Schaltmatrix nachgeschalteten Schalter aufweisen. Die Leistungselektronik kann sich für das Gleichstromladen in der Ladevorrichtung befinden. Gleichstromladen ermöglicht wegen des externen Ladegerätes sehr hohe Ladeleistungen und kurze Ladezeiten, also das sogenannte Schnellladen.

Der Ladepunkt kann bspw. wenigstens oder genau zwei Anschlüsse umfassen, um einen Ladestecker der Ladevorrichtung mit dem Fahrzeug zu verbinden und/oder einen Ladestromkreis mit dem Fahrzeug zu schließen und/oder den Ladestrom an das Fahrzeug zu übertragen. Die Anschlüsse können elektrisch jeweils mit wenigstens einer Leiterbahn der Leiterplatte verbunden sein. Die Leiterbahn kann wiederrum zu wenigstens einer der Schalteinheiten führen, welche ebenfalls an der Leiterplatte befestigt sein können.

Des Weiteren kann vorgesehen sein, dass die wenigstens eine oder mehreren Leistungseinheit(en) jeweils eine Leistungselektronik, insbesondere einen Gleichrichter (d. h. AC/DC-Wandler), aufweist bzw. aufweisen, vorzugsweise um bei der Ladevorrichtung in der Form einer Gleichstromladestation den Ladestrom in der Form von Gleichstrom bereitzustellen. Damit kann aus einer Wechselspannungsquelle der für das Aufladen notwendige Gleichstrom direkt durch die Ladevorrichtung bereitgestellt werden.

Es kann weiter möglich sein, dass mindestens zwei Ladepunkte zum parallelen Aufladen mehrerer Elektrofahrzeuge vorgesehen sind, wobei die wenigstens eine Schalteinheit dazu vorgesehen und/oder ausgebildet und/oder derart mit weiteren Schalteinheiten verschaltet ist, den bereitgestellten Ladestrom auf die Ladepunkte aufzuteilen. Bspw. kann die wenigstens eine Schalteinheit mehrere Schalteinheiten umfassen, die als eine Schaltmatrix ausgeführt sind, um die Aufteilung zu ermöglichen. Bspw. kann es vorgesehen sein, dass jede Schalteinheit eine Umleitung des Ladestroms an unterschiedliche Ladepunkte ermöglicht.

Es kann ferner möglich sein, dass mindestens zwei oder mindestens drei oder mindestens vier Schalteinheiten vorgesehen sind, um eine Schaltmatrix zur Verteilung und Aufteilung des bereitgestellten Ladestroms auszubilden. Die Schaltmatrix kann als eine GleichstromSchaltmatrix ausgeführt sein. Die Eingänge der Schaltmatrix können mit der wenigstens einen Leistungseinheit und die Ausgänge der Schaltmatrix mit dem wenigstens einen Ladepunkt verbunden sein.

Wenn mehrere Leistungseinheiten und mehrere Ladepunkte vorgesehen sind, kann mittels der Schaltmatrix eine Leistungseinheit einem beliebigen Ladepunkt der Ladevorrichtung zugeordnet sein. Bspw. kann die Schaltmatrix zwei der Schalteinheiten pro Ladepunkt aufweisen. Im geschlossenen Zustand können diese Schalteinheiten und/oder kann die Schaltmatrix die Leistungseinheit mit einem beliebigen Ladepunkt verbinden. Hiermit ermöglicht die Schaltmatrix eine dynamische Leistungsverteilung zwischen den Ladepunkten in den Leistungsstufen der elektrischen Nennleistung der Leistungseinheiten. Nicht zum Laden benötigte Leistungseinheiten verbleiben dabei im ausgeschalteten Zustand, wodurch sich die Lebensdauer der Leistungseinheiten erhöht. Die gesamte elektrische Nennleistung der Ladevorrichtung, welche durch die Leistungseinheiten bereitgestellt wird, kann ggf. größer als 50 kW sein.

Optional kann es vorgesehen sein, dass mindestens zwei oder mindestens drei oder mindestens vier Ladepunkte vorgesehen sind, und/oder mindestens vier oder mindestens sechs oder mindestens acht Schalteinheiten eine Schaltmatrix ausbilden, um den bereitgestellten Ladestrom zwischen den Ladepunkten durch eine dynamische elektrische Leistungsverteilung aufzuteilen. Je weniger Ladepunkte parallel für eine Aufladung verwendet werden, desto höher kann dabei die elektrische Leistung sein, welche über einen einzigen Ladepunkt abgegeben wird. Durch die Verteilung der elektrischen Leistung auf die Ladepunkte ergibt sich indessen eine verbesserte Verfügbarkeit der Ladevorrichtung.

Ein weiterer Vorteil kann im Rahmen der Erfindung erzielt werden, wenn die wenigstens eine Schalteinheit jeweils als Leiterplattenrelais ausgebildet ist. Bei mehreren Schalteinheiten der erfindungsgemäßen Anordnung kann entsprechend jede der Schalteinheiten als Leiterplattenrelais ausgebildet sein. Die direkte Befestigung der Schalteinheit auf der Leiterplatte ermöglicht eine einfachere und zuverlässigere Herstellung und Montage. Bevorzugt kann im Rahmen der Erfindung vorgesehen sein, dass eine (insbesondere elektronische) Kontrollvorrichtung zur Ansteuerung der wenigstens einen Schalteinheit vorgesehen ist. Die Kontrollvorrichtung kann dazu ausgeführt sein, ein Schalten der wenigstens einen Schalteinheit unter Last zu vermeiden. Ferner kann die Schalteinheit jeweils als Wechselstromrelais (kurz: AC-Relais) ausgebildet sein. Die erfindungsgemäße Anordnung kann wenigstens einen Anschluss aufweisen, um die Leiterplatte bzw. die Schaltmatrix mit der Kontrollvorrichtung zu verbinden. Dies ermöglicht eine einfache Montage und geringe Herstellungskosten.

Die wenigstens eine Schalteinheit kann jeweils als ein AC-Relais ausgebildet sein, welches erfindungsgemäß dann allerdings für DC genutzt wird (also das Schalten des Ladestroms in der Form eines Gleichstroms). Beispielsweise weist der geschaltete Ladestrom eine Spannung i. H v. mindestens 1000 V auf. AC-Relais haben üblicherweise eine unzureichende Fähigkeit zur Lichtbogenlöschung. Daher kann hier vorteilhafterweise die Kontrollvorrichtung zum Einsatz kommen, um sicherzustellen, dass die Schalteinheit stromlos (also nicht bei Vorliegen eines Stromfluss durch die Schalteinheit bzw. nur ohne Last) geschaltet wird. Daher kann es vorgesehen sein, dass vor einem Schalten der Schalteinheit der Ladestrom zunächst heruntergeregelt wird, z. B. durch die Leistungseinheit, welche entsprechend von der Kontrollvorrichtung angesteuert werden kann. Auch kann eine Strommessung durch die Kontrollvorrichtung erfolgen, um sicherzustellen, dass die Schalteinheit ohne Stromfluss geschaltet wird. In diesem Zusammenhang kann von einer Überwachung der Schalteinheiten durch die Kontrollvorrichtung gesprochen werden.

Vorteilhafterweise kann im Rahmen der Erfindung vorgesehen sein, dass die Leiterplatte als eine Dickkupfer-Leiterplatte oder Inlay-Leiterplatte ausgebildet ist. Die Leiterplatte kann z. B. eine Lagenkupferstärke von mindestens 100 µm oder mindestens 200 µm oder mindestens 300 µm oder mindestens 400 µm aufweisen, um die Belastbarkeit für die hohen Ladeströme zu gewährleisten. Ferner kann eine Kupferstärke der Leiterbahnen der Leiterplatte von mindestens 1 mm oder mindestens 1,5 mm vorgesehen sein. Es kann eine Erhöhung des Querschnitts der ladestromführenden Leiterbahnen vorgesehen sein, um thermische Grenzwerte einzuhalten. In anderen Worten kann der Querschnitt der Leiterbahnen der Leiterplatte an den Ladestrom angepasst sein.

Beispielsweise kann es vorgesehen sein, dass mindestens zwei oder mindestens drei oder mindestens vier Ladepunkte vorgesehen sind, welche ferner galvanisch voneinander isoliert sein können, um eine parallele Aufladung von Elektrofahrzeugen bereitzustellen. Beispielsweise kann die wenigstens eine Schalteinheit jeweils dazu ausgeführt sein, diese galvanische Trennung zumindest teilweise bereitzustellen.

Nach einer weiteren Möglichkeit kann vorgesehen sein, dass die wenigstens eine Schalteinheit jeweils mindestens einen Spiegelkontakt zur Funktionsüberwachung der Schalteinheit aufweist. Damit kann eine dauerhafte Überprüfung der ordnungsgemäßen Funktion der Schalteinheiten erfolgen. Die Leiterplatte kann ggf. Anschlüsse aufweisen, über die eine Kontrollvorrichtung die Überprüfung durchführen kann.

Die Spulenkontakte der Schalteinheiten und ggf. die optionalen Spiegelkontakte der Schalteinheiten, insbesondere Leiterplattenrelais, können vorteilhafterweise über Leiterbahnen der Leiterplatte mit einer zentralen Anschlussstelle verbunden sein, welche insbesondere den Anschluss eines mehrpoligen Steckverbinders erlaubt. Hierdurch reduziert sich der händische Montageaufwand weiter.

Es kann weiter möglich sein, dass mehrere Leistungseinheiten vorgesehen sind, welche galvanisch voneinander isoliert sind. Dies ermöglicht einen sicheren parallelen Betrieb der Ladepunkte.

Gemäß einer vorteilhaften Weiterbildung der Erfindung kann vorgesehen sein, dass die wenigstens eine Schalteinheit eine Stromtragfähigkeit von mindestens 100 A oder mindestens 200 A aufweist. Die Stromtragfähigkeit von 200 A kann für eine Anwendung in einer DC-Schaltmatrix ausreichend sein. Wenn allerdings AC-Relais als Schalteinheit verwendet werden, kann bei unzureichender Fähigkeit zur Lichtbogenlöschung durch eine Kontrollvorrichtung sichergestellt werden, dass das Schalten der Schalteinheiten (bzw. AC-Relais) nur stromlos erfolgt. Damit lassen sich auch AC-Relais als Schalteinheiten für eine DC-Schaltmatrix verwenden.

Ebenfalls Gegenstand der Erfindung ist eine Ladevorrichtung, aufweisend eine erfindungsgemäße Anordnung. Damit bringt die erfindungsgemäße Ladevorrichtung die gleichen Vorteile mit sich, wie sie ausführlich mit Bezug auf eine erfindungsgemäße Anordnung beschrieben worden sind.

Die Ladevorrichtung kann mittels der Leistungseinheit(en) dazu ausgeführt sein, eine elektrische Nennleistung von mindestens 50 kW für eine Aufladung des wenigstens einen Elektrofahrzeuges bereitzustellen. Zur Aufteilung dieser Nennleistung können als der wenigstens eine Ladepunkt mindestens zwei oder mindestens drei Ladepunkte vorgesehen sein. Dabei kann durch die wenigstens eine Schalteinheit, insbesondere einer Schaltmatrix aus mehreren der Schalteinheiten, eine parallele Aufladung durch eine Aufteilung der Nennleistung auf die Ladepunkte erfolgen. Jeder der Ladepunkte kann galvanisch von den anderen Ladepunkten isoliert sein. Auch kann die Ladecharakteristik an den Ladepunkten unterschiedlich sein. Die Nennleistung kann von der wenigstens einen Leistungseinheit geliefert werden. Die Leistungseinheiten können dabei gleich ausgeführt und/oder dimensioniert sein.

Ein weiterer Vorteil kann im Rahmen der Erfindung erzielt werden, wenn die Ladevorrichtung als eine Gleichstromschnellladestation ausgebildet ist, insbesondere um ein Schnellladen durch den Ladestrom in der Form von Gleichstrom für das Elektrofahrzeug bereitzustellen. Die Gleichstromschnellladestation kann eine Leistung von mindestens 50 kW oder mindestens 100 kW oder mindestens 200 kW bereitstellen.

Des Weiteren ist es denkbar, dass die Ladevorrichtung als eine einzige stationäre Ladesäule ausgebildet ist, und mindestens zwei oder drei Leistungseinheiten aufweist, um den Ladestrom über mehrere der Schalteinheiten auf mindestens drei Ladepunkte zur parallelen Aufladung jeweiliger Elektrofahrzeuge an der Ladevorrichtung aufzuteilen, wobei die Schalteinheiten jeweils als Relais ausgebildet sein können und/oder unmittelbar mit der Leiterplatte elektrisch verbunden sind.

Ebenfalls Gegenstand der Erfindung ist ein Verfahren zur Aufladung wenigstens eines Fahrzeuges, insbesondere Elektrofahrzeuges, wobei die nachfolgenden Schritte durchgeführt werden, insbesondere nacheinander oder in beliebiger Reihenfolge, wobei die Schritte auch wiederholt durchgeführt werden können:
- Bereitstellen wenigstens einer Leistungseinheit für eine Bereitstellung eines elektrischen Ladestroms und/oder einer elektrischen Leistung zur Aufladung des Fahrzeuges,
- Bereitstellen wenigstens eines Ladepunktes,
- Bereitstellen wenigstens einer Leiterplatte,
- Bereitstellen wenigstens einer Schalteinheit, welche an der Leiterplatte zum Schalten des bereitgestellten Ladestroms angeordnet ist,
- Initiieren einer Übertragung des bereitgestellten Ladestroms von der Leistungseinheit über die Schalteinheit und über den Ladepunkt an das Fahrzeug durch eine Kontrollvorrichtung, vorzugsweise um eine Aufladung des Fahrzeuges durchzuführen.

Damit bringt das erfindungsgemäße Verfahren die gleichen Vorteile mit sich, wie sie ausführlich mit Bezug auf eine erfindungsgemäße Anordnung beschrieben worden sind. Zudem kann vorteilhafterweise eine erfindungsgemäße Anordnung durch das erfindungsgemäße Verfahren betrieben werden. Die Kontrollvorrichtung kann als eine elektronische Steuereinheit oder dergleichen ausgebildet sein.

Ferner kann es vorgesehen sein, dass die Kontrollvorrichtung dadurch die Übertragung initiiert, dass die Kontrollvorrichtung die wenigstens eine Schalteinheit schließt, und/oder es kann vorgesehen sein, dass die Kontrollvorrichtung zur Deaktivierung der Übertragung den Ladestrom zunächst abschaltet und erst dann die Schalteinheit (wieder) lastfrei öffnet. Die Abschaltung kann bspw. durch eine Herunterregelung des Ladestroms durch die Leistungseinheit erfolgen. Auf diese Weise wird gewährleistet, dass die wenigstens eine Schalteinheit nicht unter Last geschaltet wird. Zur zusätzlichen Absicherung kann ggf. noch zuvor eine Messung erfolgen, dass die Schalteinheit stromlos ist.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen jeweils schematisch:
- Fig. 1: eine erfindungsgemäße Anordnung,
- Fig. 2: eine erfindungsgemäße Anordnung in einer perspektivischen Darstellung,
- Fig. 3+4: jeweils eine erfindungsgemäße Anordnung.

In den nachfolgenden Figuren werden für die gleichen technischen Merkmale auch von unterschiedlichen Ausführungsbeispielen die identischen Bezugszeichen verwendet.

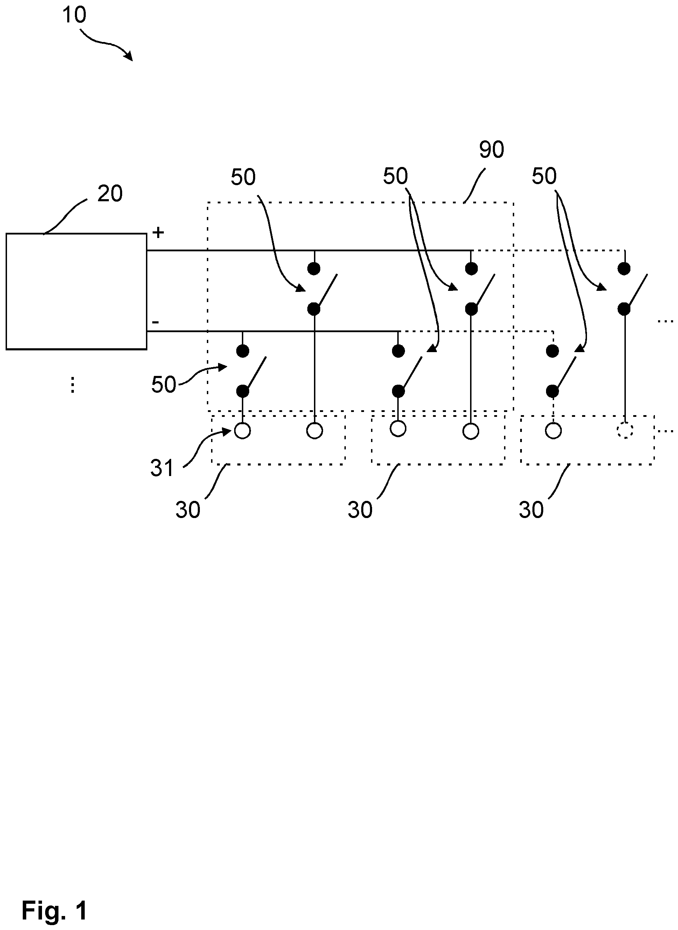

In den Figuren 1 bis 4 ist jeweils eine erfindungsgemäße Anordnung 10 zur Integration in eine Ladevorrichtung 1 für wenigstens ein Elektrofahrzeug gezeigt. Die erfindungsgemäße Anordnung 10 kann die folgenden Komponenten aufweisen:
- wenigstens eine oder mehrere Leistungseinheiten 20 für eine Bereitstellung eines elektrischen Ladestroms,
- wenigstens einen oder mehrere Ladepunkte 30,
- wenigstens eine Leiterplatte 40,
- wenigstens eine Schalteinheit 50, welche an der Leiterplatte 40 zum Schalten des bereitgestellten Ladestroms angeordnet und insbesondere elektrisch leitend befestigt ist, und somit leiterplattenbasiert ausgeführt ist.

Ferner ist anhand der Schaltbilder in den Figuren 1, 3 und 4 erkennbar, dass die wenigstens eine Schalteinheit 50 die wenigstens eine Leistungseinheit 20 mit dem wenigstens einen Ladepunkt 30 elektrisch verbindet, um den bereitgestellten Ladestrom an das Elektrofahrzeug zu übertragen. Dabei ist es vorgesehen, dass auch mehrere Schalteinheiten 50 an der Leiterplatte 40 angeordnet sind, und eine Schaltmatrix 90 bilden.

Wie in Figur 1 beispielhaft gezeigt ist, kann die Schaltmatrix 90 zwei der Schalteinheiten 50 pro Ladepunkt 30 aufweisen. Im geschlossenen Zustand können diese Schalteinheiten 50 eine der Leistungseinheiten 20 mit einem beliebigen Ladepunkt 30 verbinden. Dadurch ermöglicht die Schaltmatrix 90 eine dynamische Leistungsverteilung zwischen den Ladepunkten 30 in den Leistungsstufen der Nennleistung der Leistungseinheiten 20.

Herkömmlicherweise würden die in Figur 1 gezeigten Schalteinheiten 50 als Gleichspannungsschütze (DC-Schütze) realisiert werden. Dies würde zu einem diskreten Aufbau der Schaltmatrix 90 führen. Es müssten ferner die DC-Schütze im geschalteten Zustand einen hohen Strom führen, im nicht geschalteten Zustand die Ladespannungen sicher sperren sowie beim Schalten unter Last eine Lichtbogenlöschung sicherstellen. Die hohen technischen Anforderungen an eine Lösung unter Verwendung von DC-Schützen resultieren in einem hohen Aufwand bei der Herstellung und Montage. Durch die erfindungsgemäß vorgeschlagene leiterplattenbasierte Ausführung der Schalteinheiten 50 können diese Nachteile zumindest reduziert werden. Insbesondere kann die Funktionsweise der Schaltmatrix 90, vorzugsweise Gleichstromschaltmatrix (DC-Schaltmatrix), leiterplattenbasiert unter Verwendung von Leiterplattenschalteinheiten, vorzugsweise Leiterplattenrelais, umgesetzt werden. Vorzugsweise ist die erfindungsgemäße Anordnung 10 ferner als eine integrierte Baugruppe ausgeführt. Damit kann der Montageaufwand bei der Endmontage der Ladevorrichtung 1 deutlich reduziert und die Prozesssicherheit erhöht werden.

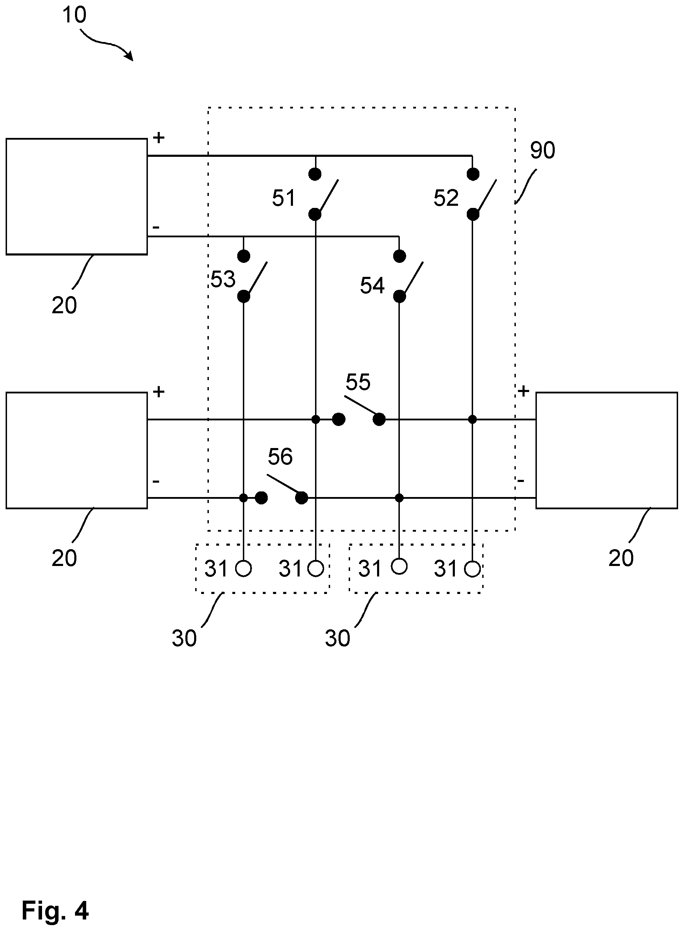

Außerdem kann es möglich sein, dass die Leistungseinheit 20 eine Leistungselektronik, insbesondere einen Gleichrichter, aufweist, um bei der Ladevorrichtung 1 in der Form einer Gleichstromladestation den Ladestrom in der Form von Gleichstrom bereitzustellen. In den Figuren 1 und 4 sind die Leistungseinheiten 20 mit den "+" und "-"-Anschlüssen dargestellt. Entsprechend können auch die Ladepunkte 30 "+" und "-"-Anschlüsse aufweisen. Die Schaltmatrix 90 kann korrespondierende "+" und "-"-Anschlüsse für die Leistungseinheiten 20 und die Ladepunkte 30 aufweisen, um darüber mit den entsprechenden Anschlüssen der Leistungseinheiten 20 bzw. Ladepunkte 30 verbunden zu werden. Ferner können Anschlüsse für die Ansteuerung der Schalteinheiten 50 durch eine Kontrollvorrichtung 80 und optionale Anschlüsse für Spiegelkontakte 70 zur Funktionsüberwachung vorgesehen sein.

Es können ferner mindestens zwei Ladepunkte 30 zum parallelen Aufladen mehrerer Elektrofahrzeuge vorgesehen sein, wobei die wenigstens eine Schalteinheit 50 dazu vorgesehen ist, den bereitgestellten Ladestrom auf die Ladepunkte 30 aufzuteilen. In Figur 1 ist veranschaulicht, dass die erfindungsgemäße Anordnung 10 auch durch weitere Ladepunkte 30, weitere Leistungseinheiten 20 und damit auch weitere Schalteinheiten 50 erweitert werden kann, um entsprechend weitere Elektrofahrzeuge parallel an der Ladevorrichtung 1 aufzuladen. Die Schaltmatrix 90 kann durch die zusätzlichen Schalteinheiten 50 in die Lage versetzt werden, die weiteren Ladepunkte 30 mit dem Ladestrom zu versorgen. Die Übertragung des Ladestroms an jeden der Ladepunkte 30 kann dabei ggf. durch die Schaltmatrix 90 schaltbar sein.

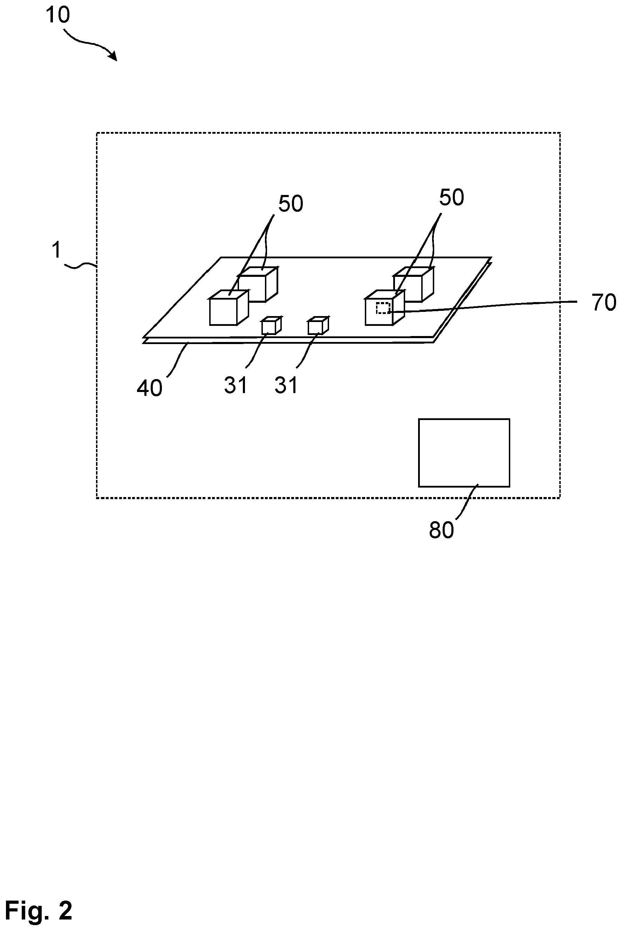

Die Figur 2 zeigt den Aufbau der erfindungsgemäßen Anordnung 10 als integrierte Baugruppe. Es ist veranschaulicht, dass die wenigstens eine Schalteinheit 50 jeweils als Leiterplattenrelais ausgebildet sein kann. Entsprechend können die Schalteinheiten 50 direkt auf der Leiterplatte 40 befestigt sein. Darüber hinaus können Anschlüsse der Leiterplatte 40 an eine Kontrollvorrichtung 80 vorgesehen sein.

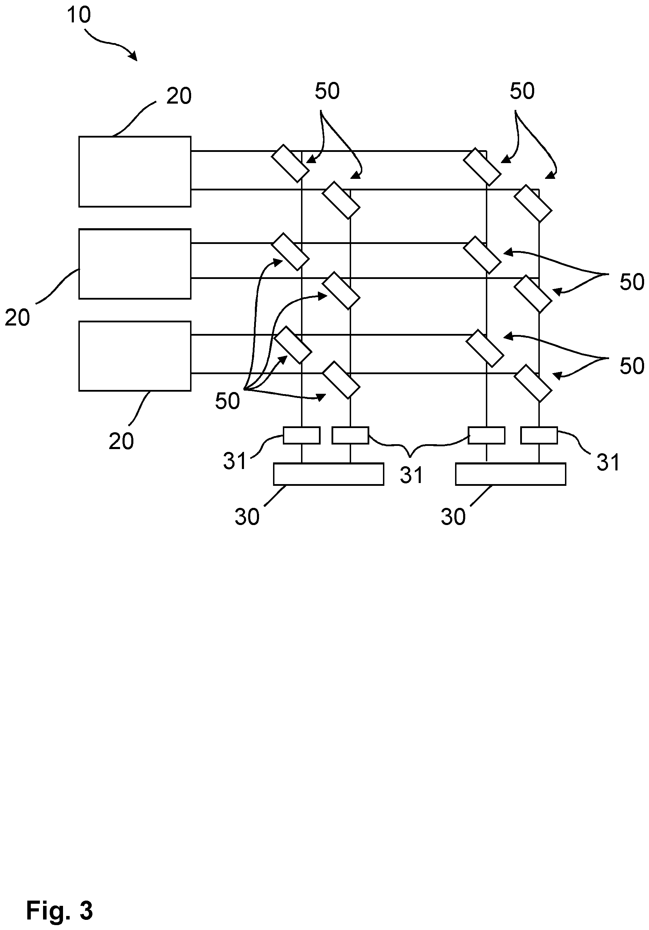

In Figur 3 ist eine weitere Ausführung der erfindungsgemäßen Anordnung 10 gezeigt, bei welcher für jeden Ladepunkt 30 sechs Schalteinheiten 50 zum Einsatz kommen. Dies ermöglicht es, den elektrischen Ladestrom, welcher von drei Leistungseinheiten 20 bereitgestellt wird, dynamisch an die Ladepunkte 30 zu verteilen und je nach Betriebszustand der Ladepunkte 30 die elektrische Leistung aufzuteilen. Die Ladepunkte 30 können jeweils zwei Anschlüsse 31 aufweisen, um einen Ladestecker mit dem Fahrzeug zum Aufladen zu verbinden, und damit die Ladepunkte 30 in den aktivierten Betriebszustand zu überführen. Nach Beendigung der Aufladung können die Ladepunkte 30 in den deaktivierten Betriebszustand überführt werden, z. B. durch ein Öffnen eines weiteren Schalters an den Anschlüssen 31.

Figur 4 zeigt beispielhaft, dass auch nur insgesamt sechs Schalteinheiten 51-56 vorgesehen sein können, um eine Schaltmatrix 90 zur Verteilung und Aufteilung des durch drei Leistungseinheiten 20 bereitgestellten Ladestroms auszubilden. Entsprechend können für jeden Ladepunkt 30 drei Schalteinheiten 50 vorgesehen sein. Um dies zu ermöglichen, werden die Leistungseinheiten 20 teilweise direkt mit den Ladepunkten 30 elektrisch verbunden. Es kann allerdings außerhalb der Schaltmatrix 90 für jeden Ladepunkt 30 ein weiterer Schalter z. B. an den Anschlüssen 31 vorgesehen sein, um die Ladepunkte 30 in den deaktivierten Betriebszustand zu überführen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Ladevorrichtung
- 10: Anordnung
- 20: Leistungseinheit
- 30: Ladepunkt
- 31: Anschluss
- 40: Leiterplatte
- 50: Schalteinheit
- 70: Spiegelkontakt
- 80: Kontrollvorrichtung
- 90: Schaltmatrix
- 51-56: Schalteinheiten

## Patentansprüche

1. Anordnung (10) zur Integration in eine Ladevorrichtung (1) für wenigstens ein Elektrofahrzeug, aufweisend:
- wenigstens eine Leistungseinheit (20) für eine Bereitstellung eines elektrischen Ladestroms,
- wenigstens einen Ladepunkt (30),
- wenigstens eine Leiterplatte (40),
- wenigstens eine Schalteinheit (50), welche an der Leiterplatte (40) zum Schalten des bereitgestellten Ladestroms angeordnet ist,
wobei die wenigstens eine Schalteinheit (50) die wenigstens eine Leistungseinheit (20) mit dem wenigstens einen Ladepunkt (30) elektrisch verbindet, um den bereitgestellten Ladestrom an das Elektrofahrzeug zu übertragen.

2. Anordnung (10) nach Anspruch 1,
**dadurch gekennzeichnet,**
**dass** die Leistungseinheit (20) eine Leistungselektronik, insbesondere einen Gleichrichter, aufweist, um bei der Ladevorrichtung (1) in der Form einer Gleichstromladestation den Ladestrom in der Form von Gleichstrom bereitzustellen.

3. Anordnung (10) nach Anspruch 1 oder 2,
**dadurch gekennzeichnet,**
**dass** mindestens zwei Ladepunkte (30) zum parallelen Aufladen mehrerer Elektrofahrzeuge vorgesehen sind, wobei die wenigstens eine Schalteinheit (50) dazu vorgesehen ist, den bereitgestellten Ladestrom auf die Ladepunkte (30) aufzuteilen.

4. Anordnung (10) nach einem der vorhergehenden Ansprüche,
**dadurch gekennzeichnet,**
**dass** mindestens zwei oder mindestens drei oder mindestens vier Schalteinheiten (51-56) vorgesehen sind, um eine Schaltmatrix (90) zur Verteilung und Aufteilung des bereitgestellten Ladestroms auszubilden.

5. Anordnung (10) nach einem der vorhergehenden Ansprüche,
**dadurch gekennzeichnet,**
**dass** mindestens zwei Ladepunkte (30) vorgesehen sind, und mindestens vier Schalteinheiten (51-56) eine Schaltmatrix (90) ausbilden, um den bereitgestellten Ladestrom zwischen den Ladepunkten (30) durch eine dynamische elektrische Leistungsverteilung aufzuteilen, und/oder dass die wenigstens eine Schalteinheit (50) jeweils als Leiterplattenrelais ausgebildet ist.

6. Anordnung (10) nach einem der vorhergehenden Ansprüche,
**dadurch gekennzeichnet,**
**dass** eine Kontrollvorrichtung (80) zur Ansteuerung der wenigstens einen Schalteinheit (50) vorgesehen ist, und dazu ausgeführt ist, ein Schalten der wenigstens einen Schalteinheit (50) unter Last zu vermeiden, wobei die Schalteinheit (50) jeweils als Wechselstromrelais ausgebildet ist.

7. Anordnung (10) nach einem der vorhergehenden Ansprüche,
**dadurch gekennzeichnet,**
**dass** die Leiterplatte (40) als eine Dickkupfer-Leiterplatte oder Inlay-Leiterplatte ausgebildet ist.

8. Anordnung (10) nach einem der vorhergehenden Ansprüche,
**dadurch gekennzeichnet,**
**dass** mindestens zwei oder mindestens drei oder mindestens vier Ladepunkte (30) vorgesehen sind, welche galvanisch voneinander isoliert sind, um eine parallele Aufladung von Elektrofahrzeugen bereitzustellen.

9. Anordnung (10) nach einem der vorhergehenden Ansprüche,
**dadurch gekennzeichnet,**
**dass** die wenigstens eine Schalteinheit (50) jeweils mindestens einen Spiegelkontakt (70) zur Funktionsüberwachung der Schalteinheit (50) aufweist.

10. Anordnung (10) nach einem der vorhergehenden Ansprüche,
**dadurch gekennzeichnet,**
**dass** mehrere Leistungseinheiten (20) vorgesehen sind, welche galvanisch voneinander isoliert sind, und/oder dass die wenigstens eine Schalteinheit (50) eine Stromtragfähigkeit von mindestens 100 A oder mindestens 200 A aufweist.

11. Ladevorrichtung, aufweisend eine Anordnung (10) nach einem der vorhergehenden Ansprüche.

12. Ladevorrichtung (1) nach Anspruch 11,
**dadurch gekennzeichnet,**
**dass** die Ladevorrichtung (1) als eine Gleichstromschnellladestation ausgebildet ist, um ein Schnellladen durch den Ladestrom in der Form von Gleichstrom für das Elektrofahrzeug bereitzustellen.

13. Ladevorrichtung (1) nach Anspruch 11 oder 12,
**dadurch gekennzeichnet,**
**dass** die Ladevorrichtung (1) als eine einzige stationäre Ladesäule ausgebildet ist, und mindestens zwei oder drei Leistungseinheiten (20) aufweist, um den Ladestrom über mehrere der Schalteinheiten (51-56) auf mindestens drei Ladepunkte (30) zur parallelen Aufladung jeweiliger Elektrofahrzeuge an der Ladevorrichtung (1) aufzuteilen, wobei die Schalteinheiten (51-56) jeweils als Relais ausgebildet sind, und unmittelbar mit der Leiterplatte (40) elektrisch verbunden sind.

14. Verfahren zur Aufladung wenigstens eines Elektrofahrzeuges, wobei die nachfolgenden Schritte durchgeführt werden:
- Bereitstellen wenigstens einer Leistungseinheit (20) für eine Bereitstellung eines elektrischen Ladestroms,
- Bereitstellen wenigstens eines Ladepunktes (30),
- Bereitstellen wenigstens einer Leiterplatte (40),
- Bereitstellen wenigstens einer Schalteinheit (50), welche an der Leiterplatte (40) zum Schalten des bereitgestellten Ladestroms angeordnet ist,
- Initiieren einer Übertragung des bereitgestellten Ladestroms von der Leistungseinheit (20) über die Schalteinheit (50) und über den Ladepunkt (30) an das Elektrofahrzeug durch eine Kontrollvorrichtung (80).

15. Verfahren nach Anspruch 14,
**dadurch gekennzeichnet,**
**dass** die Kontrollvorrichtung (80) dadurch die Übertragung initiiert, dass die Kontrollvorrichtung (80) die wenigstens eine Schalteinheit (50) schließt, wobei die Kontrollvorrichtung (80) zur Deaktivierung der Übertragung den Ladestrom zunächst abschaltet und erst dann die Schalteinheit (50) lastfrei öffnet.
